# EUROPÄISCHE PATENTSCHRIFT

(11) **EP 2 276 601 B1**
(45) Veröffentlichungstag und Bekanntmachung des Hinweises auf die Patenterteilung: **03.06.2020**
(21) Anmeldenummer: 09732668.0
(22) Anmeldetag: 15.04.2009
(51) Int. Cl.: B23K 3/047, B23K 1/005, B23K 1/008, B23K 1/00, H05K 3/34, H05B 3/00

(54) **REFLOWLÖTOFEN UND VERFAHREN ZUR REFLOW-LÖTUNG**
REFLOW SOLDER FURNACE AND METHOD FOR REFLOW SOLDERING
FOUR DE SOUDURE PAR REFUSION ET PROCÉDÉ DE SOUDURE PAR REFUSION

(30) Priorität: 15.04.2008 DE 102008019055
(43) Veröffentlichungstag der Anmeldung: 26.01.2011
(73) Patentinhaber: Endress+Hauser SE+Co. KG, 79689 Maulburg (DE)
(72) Erfinder: BIRGEL, Dietmar, 79650 Schopfheim (DE); GLATZ, Franz, 79106 Freiburg (DE); HIPPIN, Christoph, 79639 Grenzach (DE)
(74) Vertreter: Andres, Angelika Maria
(86) Internationale Anmeldenummer: PCT/EP2009/054421
(87) Internationale Veröffentlichungsnummer: WO 2009/127637

(56) Entgegenhaltungen:
- DE-A1- 19 920 432
- DE-A1-102006 017 978
- US-A- 5 770 835
- US-A1- 2004 056 068

## Beschreibung

Die Erfindung betrifft einen Reflowlötofen und ein Verfahren zur Reflow-Lötung von Bauelementen in einem Reflowlotöfen.

Moderne elektrische Geräte, insb. Messgeräte, weisen in der Regel mindestens eine Leiterplatte auf, auf der elektronische Bauteile angeordnet sind. Diese Bauteile müssen mechanisch auf der Leiterplatte befestigt werden und elektrisch an in oder auf der Leiterplatte verlaufende Leitungen angeschlossen werden. Dies geschieht üblicherweise, indem die Bauteile auf entsprechenden Stellen auf der Leiterplatte aufgebracht und in einem Lötverfahren mechanisch befestigt und elektrisch angeschlossen werden.

Ein heute gängiges Verfahren zur Lötung von Bauteilen ist das Reflow-Löten. Dabei können im Reflöw-Lötverfahren, wie z.B. in der DE 10 2005 039 829 A1, der DE 10 2006 017 978 A1 oder der DE 10 211 647 A1 beschrieben, nicht nur klassische oberflächen-montierbare Bauteile, sondern auch bedrahtete Bauteile, deren Anschlussdrähte durch entsprechende Bohrungen in der Leiterplatte hindurch gesteckt werden, oder bedrahtete Bauteile, deren Anschlussdrähte in der Leiterplatte vorgesehene Sacklockbohrungen eingesteckt werden, verlötet werden.

Beim Reflow-Löten wird in einem ersten Schritt an allen Orten auf der Leiterplatte, an denen nachfolgend Bauteile positioniert werden, im Schablonendruckverfahren Lotpaste an den entsprechenden Lötstellen auf der Leiterplatte aufgebracht.

In einem nächsten Schritt werden die Leiterplatten vorzugsweise maschinell mit den Bauteilen bestückt und mittels einer Transportvorrichtung in einen Reflow-Lötofen eingebracht.

Reflow-Lötöfen umfassen üblicherweise mehrere Vorwärmkammern und eine Lötkammer, die die bestückte Leiterplatte sukzessive durchläuft. In den Vorwärmkammern werden die bestückten Leiterplatten nach und nach aufgewärmt, bevor sie in die Lötkammer des Ofens eingebracht werden, wo die Lötung der Bauteile erfolgt. Dabei wird ein lotspezifischer Temperaturzyklus durchlaufen, der durch die Temperatur und die Verweildauer der bestückten Leiterplatte in den einzelnen Kammern gesteuert wird.

Heute werden hierzu bevorzugt Konvektionsöfen eingesetzt, in denen ein diffuser heißer Gasstrom aus reiner Heißluft oder einem aufgeheizten Gas senkrecht auf die zu verlötende Leiterplattenoberfläche geleitet wird. Übliche Temperaturen in der Lötkammer betragen bis zu 260° C bei Verweilzeiten von bis zu 30 s.

Um eine hochwertige Lötung aller auf der Leiterplatte vorgesehenen Bauteile zu erzielen, ist es wünschenswert, dass die Temperatur der Lotpaste der einzelnen Lötstellen möglichst genau der durch den lotspezifischen Temperaturzyklus vorgegebenen Solltemperatur folgt.

Dabei treten in der Regel zwei Probleme auf. Das erste Problem besteht darin, dass auch in modernen Konvektionsöfen keine völlig homogene Temperaturverteilung in der Lötkammer erzielt werden kann. Dabei können Temperaturunterschiede von bis zu 10 °C zwischen einzelnen Bereichen innerhalb der Lötkammer auftreten. Typischer Weise bildet sich in heutigen Reflowlötöfen, insb. in Konvektionsöfen eine Temperaturverteilung in der Lötkammer aus, die sich dadurch auszeichnet, dass die Temperatur in der Lötkammer über die Breite der Lötkammer hinweg in der Mitte der Lötkammer höher ist, und zu den beiden Rändern hin seitlich abfällt. Dieses Temperaturprofil ist insb. dann problematisch, wenn in der Lötkammer nacheinander Leiterplatten mit unterschiedlichen Abmessungen verlötet werden, da die Leiterplatten dann mittels der Transportvorrichtung nicht immer genau mittig durch die Lötkammer geführt werden können. Bei einer asymmetrischen Leiterplattenführung befinden sich dann unter Umständen größere Teilbereiche der Leiterplatte im Randbereich der Lötkammer, wo der Temperaturabfall in der Regel am größten ist.

Das zweite Problem besteht darin, dass die einzelnen auf der Leiterplatte angeordneten Bauteile stark unterschiedliche Massen und Wärmekapazitäten (im Folgenden thermische Massen genannt) aufweisen können. Dies führt dazu, dass sich die Lötstelle eines Bauteils mit hoher thermische Masse deutlich langsamer erwärmt als eine Lötstelle eines Bauteils mit geringerer thermische Masse, das für den gleichen Zeitraum der gleichen Temperatur in der Lötkammer ausgesetzt wird. Bauteile mit hoher thermische Masse benötigen eine höhere Wärmeenergiezufuhr, damit sich die Lötpaste auf die vorgesehene Löttemperatur erwärmt.

In der DE 10 2005 039 829 A1 ist ein Reflow-Lötofen und ein zugehöriges Lötverfahren beschrieben, bei dem auf der Oberseite einer Leiterplatte angeordnete Bauteile, die nicht ohne diese zu beschädigen der Löttemperatur ausgesetzt werden können, in einem Reflowlötvorgang verlötet werden, bei dem in der Lötkammer ober- und unterhalb der Leiterplatte Wärmeenergiequellen angeordnet sind, und eine indirekte Erwärmung der auf der Oberseite der Leiterplatte aufgebrachten Lotpaste über die unterhalb der Leiterplatte vorgesehene Wärmeenergiequelle und mehrere unterhalb der Leiterplatte vorgesehene Infrarot-Strahler erfolgt. Es ist beschrieben die Bestrahlung der Unterseite der Leiterplatte punktuell vorzunehmen, oder auf bevorzugte Bereiche zu beschränkten, indem die Unterseite der Leiterplatte durch eine entsprechende Maske abgedeckt wird. Durch diese Maske kann gezielt in einzelnen Bereichen der Leiterplatte die zugeführte Wärmeenergie erhöht werden. Die Bereitstellung, die Aufbringung der Maske und deren Entfernung im Anschluss an den Lotvorgang stellen jedoch zusätzliche Arbeitsgänge dar, die die Produktionskosten erhöhen.

Aus der US 2004/0056068 A1 ist ein Reflow-Lötofen bekannt geworden, bei dem Infrarot-Heizen allein oder in Kombination mit Konvektionsheizen zum Einsatz kommt. Durch geeignetes Ansteuern von einzelnen Infrarot-Heizstrahlern wird die Temperatur in dem Reflowofen so geregelt, dass es nicht zu einem Überhitzen und Beschädigen von Bauteilen kommt, die auf den durch den Reflowofen laufenden Leiterplatten angeordnet sind. Die IR Heizstrahler sind in reihe quer zur Durchlaufrichtung der Leiterplatten durch den Reflowofen angeordnet.

Es ist eine Aufgabe der Erfindung einen Reflow-Lötofen und ein Verfahren zur Reflow-Lötung von Bauteilen auf einer Leiterplatte in einem Reflow-Lötofen anzugeben, bei dem die Temperatur der über die Leiterplatte verteilten Lötstellen der einzelnen Bauteile innerhalb der Lötkammer möglichst genau einer durch den lotspezifischen Temperaturzyklus vorgegebenen Solltemperatur folgt.

Hierzu besteht die Erfindung in einem Reflow-Lötofen mit
- einer Lötkammer, durch die im Lötbetrieb mit Bauteilen bestückte Leiterplatten zur Lötung von deren die Bauteile mit der Leiterplatte verbindenden Lötstellen hindurch geführt werden,
- einer Heizeinrichtung, die im Lötbetrieb dazu dient, die Lötkammer auf eine vorgegebene von einem für die Lötung vorgegebenen lotspezifischen Temperaturzyklus abhängige Grundtemperatur aufzuheizen,
- einer oberhalb der Leiterplatte in der Lötkammer angeordneten eine im Lötbetrieb von der Leiterplatte eingenommene Grundfläche der Lötkammer überdeckende Anordnung von unabhängig voneinander regelbaren Infrarot-Heizelementen, und
- einer Steuerung, die im Lötbetrieb diejenigen Infrarot-Heizelemente in Betrieb nimmt, die zusammen mit der Heizeinrichtung eine möglichst homogene Erwärmung der über die Leiterplatte verteilten Lötstellen auf eine durch den lotspezifischen Temperaturzyklus vorgegebene oberhalb der Grundtemperatur liegende Solltemperatur bewirken. Erfindungsgemäß sind
   die Infrarot-Heizelemente u-förmige Strahlungselemente, wobei einer der Schenkel des durch das jeweilige Strahlungselement gebildeten u's deutlich länger als der andere Schenkel ist, die Schenkel der einzelnen u-förmigen Strahlungselemente senkrecht zu der Richtung, in der die Leiterplatten die Lötkammer durchlaufen, angeordnet sind, und die Schenkel von zwei benachbarten Strahlungselementen jeweils in entgegengesetzter Richtung zueinander weisen.

Weiter umfasst die Erfindung ein Verfahren zur Reflow-Lötung von Leiterplatten in einem erfindungsgemäßen Reflow-Lötofen, bei dem
- die auf der Leiterplatte angeordneten Bauteile alle ähnliche
   thermische Massen aufweisen, und
- diejenigen Infrarot-Heizelement betrieben werden, die in der
   Lötkammer im Bereich der Leiterplatte die homogenste Temperaturverteilung bewirken.

Weiter umfasst die Erfindung ein Verfahren zur Reflow-Lötung von Leiterplatten in einem Reflow-Lötofen gemäß der dritten Ausgestaltung, bei dem
- die auf der Leiterplatte angeordneten Bauteile alle ähnliche thermische Massen aufweisen, und
- zur Erzielung einer möglichst homogen Temperaturverteilung im Bereich der Leiterplatte alle vorgesehenen u-förmigen Strahlungselemente betrieben werden.

Weiter besteht die Erfindung in einem Verfahren zur Reflow-Lötung von Leiterplatten in einem der erfindungsgemäßen Reflow-Lötöfen, bei dem
- auf der Leiterplatte Bauteile mit unterschiedlichen thermische Masseen vorgesehen sind,
- die Bauteile anhand von deren en in mindestens zwei
   Gruppen eingeteilt werden,
- die Bauteile einer Gruppe jeweils in einem vorgegebenen Bereich der Leiterplatte angeordnet werden, und
- die Infrarot-Heizelemente derart zugeschaltet werden, dass den Bereichen in denen Bauteile mit höherer hermische Masse angeordnet sind mehr Wärmeenergie zugeführt wird, als den Bereichen in denen Bauteile mit niedrigerer thermische Masse angeordnet sind.

Weiter besteht die Erfindung in einem Verfahren zur Reflow-Lötung von Leiterplatten in einem Reflow-Lötofen gemäß der dritten Ausgestaltung, bei dem
- auf der Leiterplatte Bauteile mit unterschiedlichen thermische Massen vorgesehen sind,
- die Bauteile anhand von deren thermische Massen in zwei Gruppen eingeteilt werden,
- die Bauteile einer Gruppe jeweils in einem vorgegebenen Bereich der Leiterplatte angeordnet werden,
- die zwischen den beiden Bereichen verlaufende Trennlinie parallel zur Transportrichtung verläuft, in der die Leiterplatte im Lötbetrieb durch die Lötkammer geführt wird, und
- im Lötbetrieb diejenigen Infrarot-Heizelemente zugeschaltet werden, deren kürzerer Schenkel überwiegend über dem Bereich angeordnet ist, in dem die Bauteile mit höherer Thermische Masse angeordnet sind.

Die Erfindung und weitere Vorteile werden nun anhand der Figuren der Zeichnung, in denen drei Ausführungsbeispiele dargestellt sind, näher erläutert; gleiche Elemente sind in den Figuren mit gleichen Bezugszeichen versehen.
- Fig. 1: zeigt eine schematische Darstellung eines Reflow-Lötofens;
- Fig. 4: zeigt die Lötkammer des Reflow-Lötofens von Fig. 1 mit einer Anordnung von Infrarot-Heizelementen, die durch antiparallel zueinander angeordnete u-förmige Strahlungselemente gebildet ist; und
- Fig. 5: zeigt zeigt eine in zwei Bereiche unterteilte Leiterplatte in deren einem Bereich Bauteile mit hoher thermische Masse angeordnet sind,
und
in deren anderem Bereich Bauteile mit geringerer t angeordnet sind.

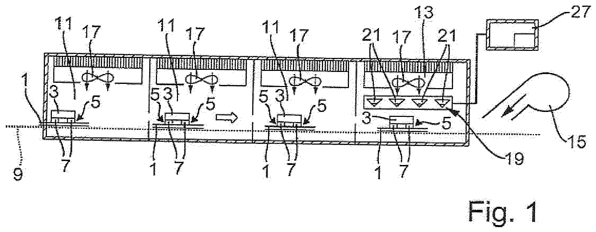

Fig. 1 zeigt eine schematische Ansicht eines Reflow-Lötofens. Der Reflow-Lötofen dient dazu auf einer Leiterplatte 1 aufgebrachte Bauteile 3 zu verlöten. Hierzu wird auf der Leiterplatte 1 an den entsprechenden Lötstellen 5 Lotpaste 7 aufgebracht und die Leiterplatte 1 wird mit den Bauteilen 3 bestückt. Anschließend wird die bestückte Leiterplatte 1 mittels einer hier nur schematisch dargestellten Transportvorrichtung 9 in den Ofen eingebracht.

Der Ofen umfasst in dem dargestellten Ausführungsbeispiel drei Vorwärmkammern 11 und eine Lötkammer 13, sowie die Transportvorrichtung 9, die dazu dient die mit den Bauteilen 3 bestückten Leiterplatten 1 sukzessive durch die einzelnen Kammern 11, 13 des Ofens zu transportieren. Am Ausgang des Ofens ist ein Kühlgebläse 15 vorgesehen, mit dem die gelöteten Leiterplatten 1 gezielt auf die Umgebungsbedingungen abgekühlt werden.

Die Vorwärmkammern 11 und die Lötkammer 13 weisen jeweils eine Heizvorrichtung 17 auf, die dazu dienen, die Vorwärmkammern 11 und die Lötkammer 13 zu erwärmen. In heutigen Konvektionsöfen erfolgt die Wärmeenergiezufuhr über die Heizvorrichtung 17 beispielsweise in Form eines heißen Gasstrom aus reiner Heißluft oder einem aufgeheizten Gas, der senkrecht auf die zu verlötende Leiterplattenoberfläche geleitet wird.

Die Heizvorrichtung 17 dient im Lötbetrieb dazu, die Lötkammer 13 auf eine vorgegebene von einem für die Lötung vorgegebenen lotspezifischen Temperaturzyklus abhängige Grundtemperatur aufzuheizen. Die Grundtemperatur folgt dabei zu jedem Zeitpunkt der durch den lotspezifischen Temperaturzyklus für den jeweiligen Zeitpunkt vorgegebenen Solltemperatur. Dabei liegt die Grundtemperatur jedoch während des gesamten Lötvorganges geringfügig unterhalb der vorgegebenen Solltemperatur.

Erfindungsgemäß ist in der Lötkammer 13 oberhalb der Leiterplatte 1 eine Anordnung 19 von unabhängig voneinander regelbaren Infrarot-Heizelementen 21 vorgesehen. Die Anordnung 19 überdeckt eine von der Leiterplatte 1 im Lötbetrieb in der Lötkammer 13 eingenommene Grundfläche der Lötkammer 13.

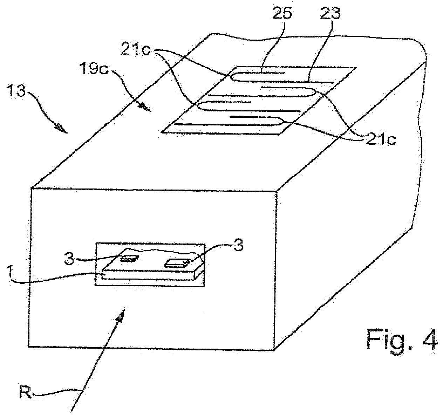

In der Figur 4 ist die erfindungsgemäße Ausgestaltung der Anordnung 19 der Infrarot-Heizelemente 21 dargestellt.

Bei der in Fig. 4 dargestellten Ausführungsform sind die Infrarot-Heizelemente 21 im wesentlichen u-förmige Strahlungselemente 21c und jedes u-förmige Strahlungselement 21c weist einen Schenkel 23 auf, der deutlich länger als der andere Schenkel 25 des jeweiligen u-förmigen Strahlungselements 21c ist. Vorzugsweise sind die kürzeren Schenkel 25 etwa halb so lang, wie die längeren Schenkel 23. Die u-förmigen Strahlungselemente 21c sind dabei derart angeordnet, dass die Schenkel 23, 25 der einzelnen u-förmigen Strahlungselemente 21c senkrecht zu der Richtung in der die Leiterplatten 1 die Lötkammer 13 durchlaufen angeordnet sind, und die Schenkel 23, 25 von zwei benachbarten u-förmigen Strahlungselementen 21c jeweils in entgegengesetzter Richtung zueinander weisen.

Zusätzlich ist eine Steuerung 27 vorgesehen, an die die einzelnen Infrarot-Heizelemente 21 einzeln angeschlossen sind. Die Steuerung 27 dient dazu, im Lötbetrieb diejenigen Infrarot-Heizelemente 21 in Betrieb zu nehmen, die zusammen mit der Heizeinrichtung 17 eine möglichst homogene Erwärmung der über die Leiterplatte 1 verteilten Lötstellen 5 auf eine durch den lotspezifischen Temperaturzyklus vorgegebene oberhalb der Grundtemperatur liegende Solltemperatur bewirken.

Dabei werden beim Betrieb des erfindungsgemäßen Reflow-Lötofens zwei Fälle unterschieden, die sich durch die thermische Massen der zu verlötenden einzelnen Bauteile 3 unterscheiden.

Im ersten Fall gilt es mit dem erfindungsgemäßen Reflow-Lötofen Bauteile 3 zu verlöten, die vergleichbare thermische Massen aufweisen. In diesem Fall werden über die Steuerung 27 diejenigen Infrarot-Heizelement 21 betrieben, die in der Lötkammer 13 im Bereich der Leiterplatte 1 zusammen mit der Heizvorrichtung 17 die homogenste Temperaturverteilung bewirken. In diesem Fall werden die Infrarot-Heizelemente 21 also gezielt ausgewählt, um durch die Heizvorrichtung 17 in der Lötkammer 13 verursachte Temperaturunterschiede auszugleichen. Die Temperaturunterschiede können beispielsweise anhand von Referenzmessungen ermittelt werden, bei denen die Lötkammer 13 ausschließlich mit der Heizvorrichtung 17 beheizt wird. Die Temperaturen von einzelnen Bereichen der Leiterplatte 1 werden hierzu beispielsweise mit auf einer Testleiterplatte angeordneten Temperatursensoren erfasst. Anhand dieser Referenzmessungen ergibt sich eine Temperaturverteilung in der Lötkammer 13, anhand derer sich Bereiche mit höheren und Bereiche mit niedrigeren Temperaturen bestimmen lassen. Anhand dieser Temperaturverteilung werden diejenigen Infrarot-Heizelemente 21 ausgewählt, deren Wärmestrahlung überwiegend auf die Bereiche ausgerichtet ist, in denen ohne die Infrarot-Heizelemente 21 niedrigere Temperaturen gemessen wurden.

Anschließend wird im Lötbetrieb die Heizeinrichtung 17 in Kombination mit den ausgewählten Infrarot-Heizelementen 21 betrieben, wobei über die Heizeinrichtung 17 die Grundtemperatur erzeugt wird, und diese über die ausgewählten Infrarot-Heizelemente 21 auf die zeitabhängige von dem lötspezifischen Temperaturzyklus vorgegebene Solltemperatur erhöht wird. Dabei werden die ausgewählten Infrarot-Heizelemente 21 über die Steuerung 27 eingeschaltet. Zusätzlich kann die Heizleistung der einzelnen ausgewählten Infrarot-Heizelemente 21 über die Steuerung 27 in Abhängigkeit von den in der Referenzmessung gemessenen Temperaturen in den einzelnen Bereichen der Leiterplatte 1 eingestellt werden.

Wenn die allein durch Heizeinrichtung 17 bewirkte Temperaturverteilung in der Lötkammer 13 nicht bekannt ist, wird die in Fig. 4 dargestellte Anordnung mit den u-förmigen Infrarot-Heizelementen 21c eingesetzt. Dabei werden zur Erzielung einer möglichst homogen Temperaturverteilung im Bereich der Leiterplatte 1 alle vorgesehenen u-förmigen Strahlungselemente 21c betrieben.

In heutigen Reflowlötöfen entsteht durch die Heizeinrichtung 17 in typischer Weise eine Temperaturverteilung in der Lötkammer 13, die sich dadurch auszeichnet, dass die Temperatur in der Lötkammer 13 entlang der Richtung in der die Leiterplatten 1 die Lötkammer 13 durchlaufen in der Mitte der Lötkammer 13 höher ist, und zu den beiden Rändern hin seitlich abfällt. Dieses Temperaturprofil ist insb. dann problematisch, wenn in der Lötkammer 13 Leiterplatten 1 mit unterschiedlichen Abmessungen verlötet werden, da die Leiterplatten 1 dann mittels der Transportvorrichtung 9 nicht immer genau mittig durch die Lötkammer 13 geführt werden können. Bei einer solchen asymmetrischen Leiterplattenführung durchlaufen dann unter Umständen größere Teilbereiche der Leiterplatte den Randbereich der Lötkammer 13, wo der Temperaturabfall in der Regel am größten ist.

Dieses sehr häufig auftretende Problem wird durch den Einsatz des erfindungsgemäßen Reflowlötofens vermieden. Hierzu wird die in Fig. 4 dargestellte Anordnung mit den u-förmigen Infrarot-Heizelementen 21c eingesetzt. Dabei werden zur Erzielung einer möglichst homogen Temperaturverteilung im Bereich der Leiterplatte 1 alle vorgesehenen u-förmigen Strahlungselemente 21c betrieben. Dies bewirkt, dass die durch u-förmigen Strahlungselemente 21c zusätzlich zugeführte Wärmeenergie über die Breite der Lötkammer 13 am Rand deutlich höher ist, als in der Mitte der Lötkammer 13. Durch das Zusammenwirken der Heizeinrichtung 17 und der Anordnung 19 von Infrarot-Heizelemten 21c wird eine homogene Temperaturverteilung erreicht, und auf die Leiterplatte 1 einwirkende Temperaturgradienten werden vermieden. Entsprechend kann auch bei asymmetrisch zur Ofenmitte eingeführten Leiterplatten 1 bzw. für Leiterplatten 1 mit unterschiedlichen Abmessungen eine sehr genaue Einstellung der Temperatur aller über die Leiterplatte 1 verteilten Lötstellen 15 auf die Solltemperatur erzielt werden.

Im zweiten Fall gilt es mit dem erfindungsgemäßen Reflow-Lötofen Bauteile 3a, 3b zu verlöten, die unterschiedliche thermische Massen aufweisen. Lötstellen 5 von Bauteilen 3a mit niedriger thermische Masse benötigen weniger zugeführte Wärmeenergie, um auf die Solltemperatur aufgeheizt zu werden, als Lötstellen 5 von Bauteilen 3b mit höherer thermische Masse.

Hier wird erfindungsgemäß derart verfahren, dass die Bauteile 3 anhand von deren thermische Massen in mindestens zwei Gruppen eingeteilt werden, und die Bauteile einer Gruppe jeweils in einem für die jeweilige Gruppe vorgegebenen Bereich Leiterplatte 1 angeordnet werden.

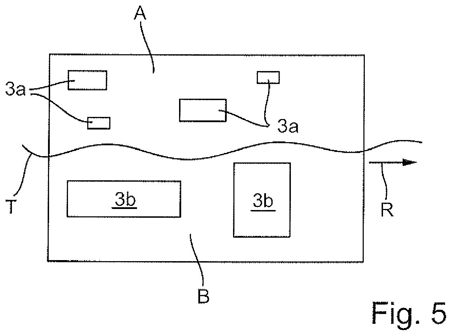

Fig. 5 zeigt eine Leiterplatte 1 die in zwei Bereiche A und B unterteilt ist. In dem ersten Bereich A befinden sich die Bauteile 3a mit niedriger thermische Masse und in dem zweiten Bereich B sind die Bauteile 3b mit hoher thermische Masse angeordnet. Die hier gewellt eingezeichnete Trennlinie T zwischen den beiden Bereichen A und B verläuft vorzugsweise parallel zu der Richtung R in der die Leiterplatte 1 durch die Lötkammer 13 geführt wird.

Dem unterschiedlichen Wärmeenergiebedarf der einzelnen Bereiche A, B kann in dem erfindungsgemäßen Reflow-Lötofen ohne weiteres Rechnung getragen werden. Hierzu werden die Infrarot-Heizelemente 21 derart zugeschaltet, dass den Bereichen B in denen Bauteile 3b mit höherer thermische Masse angeordnet sind mehr Wärmeenergie zugeführt wird, als den Bereichen A in denen die Bauteile 3a mit niedrigerer thermische Masse angeordnet sind. In diesem Fall werden die Infrarot-Heizelemente 21 also gezielt ausgewählt, um durch die unterschiedlichen thermische Massen bedingten unterschiedlichen Wärmeenergiebedarf der einzelnen Bereiche A, B zu decken.

Besonders gute Lötergebnisse werden dabei für die in Fig. 5 dargestellten in zwei Bereiche A, B eingeteilte Leiterplatte 1 in Verbindung mit der in Fig. 4 dargestellten Anordnung 21c von u-förmigen Infrarot-Heizelementen 21c erreicht, indem im Lötbetrieb diejenigen Infrarot-Heizelemente 21c zugeschaltet werden, deren kürzere Schenkel 25 im wesentlichen über dem Bereich B angeordnet sind, in dem die Bauteile 3b mit höherer thermische Masse angeordnet sind. Hierdurch wird erreicht, dass die durch die Infrarot-Heizelemente 21c zusätzlich generierte Heizleistung in dem Bereich B, in dem die Bauteile 3b mit der höheren thermische Masse angeordnet sind, deutlich größer ist, als in dem mit den Bauteilen 3a mit niedrigerer thermische Masse bestückten Bereich A. Dabei tragen im Bereich B, in dem die höhere Wärmemenge erforderlich ist, beide Schenkel 23, 25 zur Erhöhung der Heizleistung bei, während in dem Bereich A, in dem die Bauteile 3a mit der niedrigeren thermische Masse angeordnet sind, nur die längeren Schenkel 23 der jeweiligen Infrarot-Heizelemente 21c zur Erhöhung der Heizleistung beitragen.

Vorzugsweise wird in dem zweiten Fall, also bei der Verlötung von Leiterplatten 1 auf denen Bauteile 3a, 3b mit unterschiedlichen thermische Massen angeordnet sind, durch die entsprechende Zuschaltung der Infrarot-Heizelemente 21 und vorzugsweise auch durch die Steuerung von deren Heizleistung, nicht nur der durch die unterschiedlichen thermische Massen bestehende ortsabhängige zusätzliche Wärmeenergiebedarf bereitgestellt, sondern zeitgleich auch die ohne die Infrarot-Heizelemente 17 in der Lötkammer 13 vorliegende ortsabhängige Temperaturverteilung in der Lötkammer 13 berücksichtigt und kompensiert. Dabei werden die Infrarot-Heizelemente 21 also gezielt ausgewählt und betrieben, um sowohl die durch die Heizvorrichtung 17 in der Lötkammer 13 verursachten Temperaturunterschiede auszugleichen, als auch um den durch die unterschiedlichen thermische Massen verursachten unterschiedlichen Wärmeenergiebedarf der einzelnen Bereiche A, B abzudecken.

| | |
|---|---|
| 1 | Leiterplatte |
| 3 | Bauteil |
| 3a | Bauteile mit niedriger thermische Masse |
| 3b | Bauteile mit hoher thermische Masse |
| 5 | Lötstellen |
| 7 | Lotpaste |
| 9 | Transportvorrichtung |
| 11 | Vorwärmkammer |
| 13 | Lötkammer |
| 15 | Kühlgebläse |
| 17 | Heizvorrichtung |
| 19 | Anordnung von Infrarot-Heizelementen |
| 19a | Anordnung von Punktstrahlern |
| 19b | Anordnung von stabförmigen Strahl ungselementen |
| 19c | Anordnung von u-förmigen Strahlungselementen |
| 21 | Infrarot-Heizelemente |
| 21a | Punktstrahler |
| 21b | stabförmige Strahlungselemente |
| 21c | u-förmige Strahlungselemente |
| 23 | längerer Schenkel |
| 25 | kürzerer Schenkel |
| 27 | Steuerung |

## Patentansprüche

1. Reflow-Lötofen mit
- einer Lötkammer (13), durch die im Lötbetrieb mit Bauteilen (3, 3a, 3b) bestückte Leiterplatten (1) zur Lötung von deren die Bauteile (3, 3a, 3b) mit der Leiterplatte (1) verbindenden Lötstellen (5) hindurch geführt werden,
- einer Heizeinrichtung (17), die im Lötbetrieb dazu dient, die Lötkammer (13) auf eine vorgegebene von einem für die Lötung vorgegebenen lotspezifischen Temperaturzyklus abhängige Grundtemperatur aufzuheizen,
- einer oberhalb der Leiterplatte (1) in der Lötkammer (13) angeordneten eine im Lötbetrieb von der Leiterplatte (1) eingenommene Grundfläche der Lötkammer (13) überdeckenden Anordnung (19) von unabhängig voneinander regelbaren Infrarot-Heizelementen (21), und
- einer Steuerung (27), die im Lötbetrieb diejenigen Infrarot-Heizelemente (21) in Betrieb nimmt, die zusammen mit der Heizeinrichtung (17) eine möglichst homogene Erwärmung der über die Leiterplatte (1) verteilten Lötstellen (5) auf eine durch den lotspezifischen Temperaturzyklus vorgegebene oberhalb der Grundtemperatur liegende Solltemperatur bewirken **dadurch gekennzeichnet, dass** die Infrarot-Heizelemente (21) U-förmige Strahlungselemente (21 c) sind, wobei ein Schenkel (23) des durch das jeweilige Strahlungselement (21c) gebildeten U's deutlich länger als der andere Schenkel (25) ist, wobei die Schenkel (23, 25) der einzelnen Strahlungselemente (21 c) senkrecht zu der Richtung in der die Leiterplatten (1) die Lötkammer (13) durchlaufen angeordnet sind, und wobei die Schenkel (23, 25) von zwei benachbarten Strahlungselementen (21c) jeweils in entgegengesetzter Richtung zueinander weisen

2. Verfahren zur Reflow-Lötung von Leiterplatten (1) in einem Reflow-Lötofen gemäß Anspruch 1, bei dem
- die auf der Leiterplatte (1) angeordneten Bauteile (3) alle ähnliche thermische Massen aufweisen, und
- diejenigen Infrarot-Heizelement (21) betrieben werden, die in der Lötkammer (13) im Bereich der Leiterplatte (1) die homogenste Temperaturverteilung bewirken.

3. Verfahren zur Reflow-Lötung von Leiterplatten (1) in einem Reflow-Lötofen gemäß Anspruch 2, bei dem
- die auf der Leiterplatte (1) angeordneten Bauteile (3) alle ähnliche thermische Massen aufweisen, und
- zur Erzielung einer möglichst homogen Temperaturverteilung im Bereich der Leiterplatte (1) alle vorgesehenen u-förmigen Strahlungselemente (21c) betrieben werden.

4. Verfahren zur Reflow-Lötung von Leiterplatten (1) in einem Reflow-Lötofen gemäß Anspruch 2 oder 3, bei dem
- auf der Leiterplatte (1) Bauteile (3a, 3b) mit unterschiedlichen thermische Massen vorgesehen sind,
- die Bauteile (3a, 3b) anhand von deren thermische Massen in mindestens zwei Gruppen eingeteilt werden,
- die Bauteile (3a, 3b) einer Gruppe jeweils in einem vorgegebenen Bereich (A, B) der Leiterplatte (1) angeordnet werden, und
- die Infrarot-Heizelemente (21) derart zugeschaltet werden, dass den Bereichen (B) in denen Bauteile (3b) mit höherer thermische Masse angeordnet sind mehr Wärmeenergie zugeführt wird, als den Bereichen (A) in denen in denen Bauteile (3a) mit niedrigerer thermische Masse angeordnet
sind.

5. Verfahren zur Reflow-Lötung von Leiterplatten (1) in einem Reflow-Lötofen gemäß Anspruch 1, bei dem
- auf der Leiterplatte (1) Bauteile (3a, 3b) mit unterschiedlichen thermische Massen vorgesehen sind,
- die Bauteile (3a, 3b) anhand von deren thermische Massen in zwei Gruppen
eingeteilt werden,
- die Bauteile (3a, 3b) einer Gruppe jeweils in einem vorgegebenen Bereich (A, B) der Leiterplatte (1) angeordnet werden,
- eine zwischen den beiden Bereichen (A, B) verlaufende Trennlinie (T) parallel zu der Richtung (R) verläuft, in der die Leiterplatte (1) im Lötbetrieb durch die Lötkammer (13) geführt wird, und
- im Lötbetrieb diejenigen u-förmigen Strahlungselemente (21c) zugeschaltet sind, deren kürzerer Schenkel (25) überwiegend über dem Bereich (B) angeordnet ist, in dem die Bauteile (3b) mit höherer thermische Masse angeordnet sind.

## Claims

1. Reflow solder furnace, with
- a solder chamber (13) through which printed circuit boards (1) fitted with components (3, 3a, 3b) are passed during solder operation for the purpose of soldering the solder points (5) connecting the components (3, 3a, 3b) to the printed circuit board (1),
a heating unit (17) which is used, during the soldering operation, to heat the solder chamber (13) to a base temperature which depends on a solder-specific temperature cycle predefined for the soldering,
- an arrangement (19) of infrared heating elements (21) which can be regulated independently of one another, said elements being arranged above the printed circuit board (1), in the solder chamber (13), and covering over a base surface of the solder chamber which the printed circuit board (1) occupies during the soldering,
- a controller (27) which, during the soldering process, puts into operation the infrared elements (21) which, together with the heating unit (17), make it possible to heat the solder points (5) distributed over the printed circuit board (1) as homogeneously as possible to a target temperature that is above the base temperature and is predefined by the solder-specific temperature cycle,
**characterized in that**
the infrared heating elements (21) are U-shaped radiation elements (21c), wherein a leg (23) of the U formed by the particular radiation element (21c) is much longer than the other leg (25), wherein the legs (23, 25) of the individual radiation elements (21c) are arranged perpendicular to the direction in which the printed circuit boards (1) pass through the solder chamber (13), and wherein the legs (23, 25) of two adjacent radiation elements (21c) point towards one another in the opposite direction.

2. Procedure for the reflow soldering of printed circuit boards (1) in a reflow solder furnace as claimed in Claim 1, wherein
- the components (3) arranged on the printed circuit board (1) all have similar thermal masses, and
- the infrared heating elements (21) that enable the most homogeneous temperature distribution in the solder chamber in the area of the printed circuit board (1) are the elements that are put into operation.

3. Procedure for the reflow soldering of printed circuit boards (1) in a reflow solder furnace as claimed in Claim 2, wherein
- the components (3) arranged on the printed circuit board (1) all have similar thermal masses, and
- all the U-shaped radiation elements (21c) provided are operated to achieve a temperature distribution in the area of the printed circuit board (1) that is as homogeneous as possible.

4. Procedure for the reflow soldering of printed circuit boards (1) in a reflow solder furnace as claimed in Claim 2 or 3, wherein
- components (3a, 3b) with different thermal masses are provided on the printed circuit board (1),
- the components (3a, 3b) are divided into at least two groups based on their thermal masses,
- the components (3a, 3b) of a group are each arranged in a predefined area (A, B) of the printed circuit board (1), and
- the infrared heating elements (21) are activated in such a way that more thermal energy is supplied to the areas (B) in which components (3b) with a higher thermal mass are arranged than to areas (A) in which components (3a) with a lower thermal mass are arranged.

5. Procedure for the reflow soldering of printed circuit boards (1) in a reflow solder furnace as claimed in Claim 1, wherein
- components (3a, 3b) with different thermal masses are provided on the printed circuit board (1),
- the components (3a, 3b) are divided into two groups based on their thermal masses,
- the components (3a, 3b) of a group are each arranged in a predefined area (A, B) of the printed circuit board (1),
- a separation line (T) running between the two areas (A, B) is parallel to the direction (R) in which the printed circuit board (1) is passed through the solder chamber (13) during the soldering process, and
- during the soldering process, the U-shaped radiation elements (21c) whose shorter leg (25) is primarily arranged over area (B) in which the components (3b) with a higher thermal mass are arranged are activated during the soldering.

## Revendications

1. Four de brasage par refusion, avec
- une chambre de brasage (13), à travers laquelle sont acheminées, lors du brasage, les cartes de circuit imprimé (1) équipées de composants (3, 3a, 3b) pour le brasage des points de brasage (5) reliant les composants (3, 3a, 3b) avec la carte de circuit imprimé (1),
un dispositif de chauffage (17) qui, pendant le brasage, sert à échauffer la chambre de brasage (13) à une température de base dépendant d'un cycle de température spécifique au brasage, prédéfini pour le brasage,
- un agencement (19) d'éléments chauffants infrarouge (21) réglables indépendamment les uns des autres, lesquels éléments sont disposés au-dessus de la carte de circuit imprimé (1), dans la chambre de brasage (13), et recouvrent une surface de base de la chambre de brasage, laquelle surface est adoptée pendant le brasage par la carte de circuit imprimé (1),
- une commande (27) qui, pendant le brasage, met en service les éléments infrarouge (21) qui, en combinaison avec le dispositif de chauffage (17), permettent de créer un échauffement aussi homogène que possible des points de brasage (5) répartis sur la carte de circuit imprimé (1), à une température de consigne située au-delà de la température de base et prédéfinie par un cycle de température spécifique au brasage,
**caractérisé**
**en ce que** les éléments chauffants infrarouge (21) sont des éléments rayonnants en forme de U (21c), une branche (23) de l'U formé par l'élément rayonnant (21c) respectif étant nettement plus longue que l'autre branche (25), les branches (23, 25) des différents éléments rayonnants (21c) étant disposés perpendiculairement à la direction dans laquelle les cartes de circuit imprimé (1) traversent la chambre de brasage (13), et les branches (23, 25) de deux éléments rayonnants (21c) voisins étant respectivement orientées en direction opposée l'une par rapport à l'autre.

2. Procédé destiné au brasage par refusion de cartes de circuit imprimé (1) dans un four de brasage par refusion selon la revendication 1, pour lequel
- les composants (3) disposés sur la carte du circuit imprimé (1) présentent tous des masses thermiques similaires, et
- sont utilisés les éléments chauffants infrarouge (21), qui permettent d'obtenir la répartition la plus homogène de la température dans la chambre de brasage, dans la zone de la carte du circuit imprimé (1).

3. Procédé destiné au brasage par refusion de cartes de circuit imprimé (1) dans un four de brasage par refusion selon la revendication 2, pour lequel
- les composants (3) disposés sur la carte de circuit imprimé (1) présentent tous des masses thermiques similaires, et
- tous les éléments rayonnants en forme de U (21c) prévus sont utilisés afin d'obtenir une répartition la plus homogène possible de la température dans la zone de la carte du circuit imprimé (1).

4. Procédé destiné au brasage par refusion de cartes de circuit imprimé (1) dans un four de brasage par refusion selon la revendication 2 ou 3, pour lequel
- sont prévus, sur la carte de circuit imprimé (1), des composants (3a, 3b) présentant des masses thermiques différentes,
- les composants (3a, 3b) sont répartis en au moins deux groupes sur la base de leurs masses thermiques,
- les composants (3a, 3b) d'un groupe sont chacun disposés dans une zone prédéfinie (A, B) de la carte de circuit imprimé (1), et
- les éléments chauffants infrarouge (21) sont mis en circuit de telle sorte qu'est acheminée, aux zones (B) dans lesquelles sont disposés des composants (3b) présentant une masse thermique supérieure, une énergie thermique supérieure à celle acheminée aux zones (A), dans lesquelles sont disposés des composants (3a) présentant une masse thermique inférieure.

5. Procédé destiné au brasage par refusion de cartes de circuit imprimé (1) dans un four de brasage par refusion selon la revendication 1, pour lequel
- sont prévus, sur la carte de circuit imprimé (1), des composants (3a, 3b) présentant des masses thermiques différentes,
- les composants (3a, 3b) sont répartis en deux groupes sur la base de leurs masses thermiques,
- les composants (3a, 3b) d'un groupe sont chacun disposés dans une zone prédéfinie (A, B) de la carte de circuit imprimé (1),
- une ligne de séparation (T) passant entre les deux zones (A, B) est parallèle à la direction (R), dans laquelle la carte de circuit imprimé (1) est acheminée à travers la chambre de brasage (13) lors du brasage, et
- sont mis en circuit, pendant le brasage, les éléments rayonnants en forme de U (21c), dont la branche courte (25) est disposée principalement sur la zone (B), zone dans laquelle sont disposés les composants (3b) de masse thermique supérieure.
